## Europäisches Patentamt
## European Patent Office
## Office européen des brevets

(19)

(11) Veröffentlichungsnummer: **0 189 106 B1**

# (12) EUROPÄISCHE PATENTSCHRIFT

(45) Veröffentlichungstag der Patentschrift: **23.10.91**

(51) Int. Cl.⁵: **H03H 9/64**, H03H 3/08, H03H 9/02

(21) Anmeldenummer: **86100456.2**

(22) Anmeldetag: **15.01.86**

(54) **Mit akustischen Wellen arbeitendes Filter.**

(30) Priorität: **22.01.85 DE 3501977**

(43) Veröffentlichungstag der Anmeldung:
**30.07.86 Patentblatt 86/31**

(45) Bekanntmachung des Hinweises auf die
Patenterteilung:
**23.10.91 Patentblatt 91/43**

(84) Benannte Vertragsstaaten:
**AT DE FR GB IT NL**

(56) Entgegenhaltungen:
**EP-A- 0 016 979**
**EP-A- 0 124 019**
**US-A- 3 970 970**

(73) Patentinhaber: **SIEMENS AKTIENGESELL-
SCHAFT
Wittelsbacherplatz 2
W-8000 München 2(DE)**

(72) Erfinder: **Bulst, Wolf-Eckhard, Dipl.-Phys.
Arnikastrasse 2
W-8011 Vaterstetten(DE)**
Erfinder: **Erthel, Mira
Alemannenstrasse 14
W-8000 München 90(DE)**
Erfinder: **Zibis, Peter, Dipl.-Ing.
Kafkastrasse 14
W-8000 München 83(DE)**

**Beschreibung**

Die vorliegende Erfindung bezieht sich auf eine Verbesserung für die Struktur eines Filters, das mit in einem Substrat oberflächennah laufenden akustischen Wellen arbeitet, wie im Oberbegriff des Patentanspruches 1 angegeben.

Ein die Erfindung betreffendes Filter kann nicht nur mit akustischen Oberflächenwellen (Rayleigh- und Bleustein-Wellen) im engen Sinne, sondern auch mit Lamb-Wellen, Love-Wellen, Surface-Skimming-Bulk-Wellen und dgl. betrieben werden, die in einem Substrat zumindest oberflächennah verlaufen. Welche Wellenart im Einzelfall erzeugt wird, hängt von dem Fachmann bekannten Maßnahmen der Dimensionierung der Wandler und ggf. auch von Anisotropie-Eigenschaften des Substrats ab.

Oberflächenwellen-Resonatorfilter im Sinne der Erfindung besitzen auf einem piezoelektrischen Substrat angeordnete Digitalstrukturen, zu denen als Wandler zu verwendende Interdigitalstrukturen und Reflektorstrukturen gehören. Interdigitalstrukturen bestehen aus benachbart abwechselnd elektrisch angeschlossene bzw. miteinander verbundenen Streifenelektroden. Die Digitalstruktur eines Reflektors besteht aus streifenförmigen Fingern, Fingerstücken, dots, oder dgl., die vorzugsweise auf der Substratoberfläche aufgebrachte Metallisierungsstreifen sind.

Anordnung und Bemessung der Finger, Streifen und dgl. einer jeweiligen der Strukturen richten sich nach den Vorgaben für das jeweilige Filter. Die Grundsätze für Bemessungen und Abmessungen der Digitalstrukturen sind bekannt. Es sei hierzu des weiteren verwiesen auf DE-A-29 09 705, US-A-4 325 037, DE-A-33 14 725(≙EP-A-0124 019).

Für Interdigitalstrukturen sind Sammelschienen (bus bars) vorgesehen, mit denen die Finger der jeweils einen Fingerstruktur miteinander verbunden sind. Die eine Fingerstruktur greift mit diesen Fingern kammartig in eine entsprechende zweite Fingerstruktur herein und bildet mit dieser zusammen die Interdigitalstruktur. An diese seitlich der Interdigitalstruktur angeordneten Sammelschienen schließt sich jeweils ein üblicherweise flächenmäßig relativ großes (Anschluß-) Pad an. Die für die als Wandler verwendete Interdigitalstruktur erforderlichen Zuleitungsdrähte sind an diesen Pads angeschlossen, die mit der jeweiligen Sammelschiene verbunden sind bzw. einen Anteil derselben bilden.

Die Qualität und Leistungsfähigkeit eines derartigen Oberflächenwellenfilters hängt unter anderem ab von der exakten Ausbildung, Positionierung und präzisen scharfkantigen Begrenzung der streifenförmigen Finger der jeweiligen Digitalstruktur, sei es, daß es sich dabei um eine Interdigitalstruktur oder um eine Reflektorstruktur handelt.

Es ist eine Aufgabe der vorliegenden Erfindung, eine solche Struktur bzw. Strukturen für ein Oberflächenwellenfilter anzugeben, das diese Erfordernisse in optimaler Weise erfüllt.

Diese Aufgabe wird mit einer solchen Oberflächenwellen-Filterstruktur gelöst, bei der der jeweiligen Struktur am freien Ende derselben ein aus weiteren streifenförmigen Belegungen bestehendes Kollektiv hinzugefügt ist, und zwar so wie dies im Patentanspruch 1 näher angegeben ist. Hier ist anzumerken, daß die erfindungsgemäßen Kollektive reflexionsfrei ausgebildet sind und somit mit Kollektiven, die als Reflektor wirken (vgl. z.B. die US-A-3 970 970) nicht vergleichbar sind.

Die Digitalstrukturen von Oberflächenwellenfiltern werden fotolithografisch in Verbindung mit Abhebe-(lift off-) Technik oder Ätztechnik hergestellt. Der vorliegenden Erfindung liegt die Erkenntnis zugrunde, daß bei der fotolithografischen Übertragung, des Musters bzw. der Vorlage auf die über der Substratoberfläche des Filters zu diesem Zeitpunkt vorhandene fotoempfindliche Schicht, und zwar insbesondere bei Projektionsübertragung, Probleme dadurch auftreten, daß eine jegliche herzustellende Digitalstruktur (in einer Richtung gesehen) zwangsläufig erste und letzte streifenförmige Belegungen (Finger, Digitstreifen) besitzt und sich diesem jeweiligen Ende der Digitalstruktur (wenigstens im Regelfall) ein Flächenbereich der Substratoberfläche anschließt, der frei von weiteren streifenförmigen Belegungen der Strukturen ist. Für den mittleren bzw. inneren Bereich einer mit Belichtung fotolithografisch herzustellenden Digitalstruktur genügen mittlere Belichtungswerte, die kleiner sind als die Belichtungswerte, die für die ersten bzw. letzten streifenförmigen Belegungen nötig sind. Bei angepaßter Einstellung der Belichtung auf den mittleren Bereich einer Struktur führt dies zu Unterbelichtung dieser ersten und letzten streifenförmigen Belegungen oder umgekehrt erfährt der mittlere Bereich Überbelichtung, wenn der Anfangs- und Endbereich der betreffenden Struktur exakt bemessen belichtet wird.

Das vorgenannte Problem mit differenziert gewählter Belichtung zu beheben, wäre sehr aufwendig und es wurde nach anderweitiger Abhilfe gesucht. Diese wurde in Hinzufügungen von Kollektiven, bestehend aus weiteren streifenförmigen Belegungen, gefunden. Diese weiteren streifenförmigen Belegungen sind gleich oder wenigstens vergleichbar mit den streifenförmigen Belegungen der betreffenden Digitalstruktur, die bzw. deren Herstellung mit der Erfindung im Sinne der Aufgabenstellung verbessert wird.

Allein vom Gesichtspunkt der mit der Erfindung erreichten Egalisierung des Belichtungswertes für die jeweilige gesamte Digitalstruktur würde es genügen, lediglich einige, z.B. fünf bis zwanzig, weitere streifenförmige Belegungen vorzusehen, die nicht mehr (dem betreffenden Ende) der Digitalstruktur, sondern dem Kollektiv zuzurechnen sind. Insbesondere bei einer als Resonatorstruktur ausgeführten (nicht-interdigitalen) Digitalstruktur würde diese Maßnahme allein noch unzureichend sein, denn die streifenförmigen Belegungen des Kollektivs würden sich von denjenigen der eigentlichen Resonator-Digitalstruktur funktionell nicht unterscheiden.

Als weitere Maßnahme ist bei der Erfindung vorgesehen, diese weiteren streifenförmigen Belegungen des jeweiligen Kollektivs so zu positionieren, daß dieses betreffende Kollektiv für das Filter reflexionsfrei wirksam ist, und zwar bezogen auf die Welle der Digitalstruktur, der dieses Kollektiv hinzugefügt ist bzw. bezogen auf die im Filter auftretende Welle, die von der schmalbandigsten Struktur des Filters bestimmt ist und die auch durch bzw. in der Digitalstruktur läuft, der dieses betreffende Kollektiv hinzugefügt ist.

Dem steht nicht entgegen, daß ein solches Kollektiv den gesamten Zwischenraum zwischen zwei in Längsrichtung bzw. Laufrichtung der Welle des Filters aufeinanderfolgende Digitalstrukturen ausfüllen kann, d.h. das Kollektiv von der einen Digitalstruktur lückenlos bis an die (eine) benachbarte Digitalstruktur heranreicht, so daß dieses Kollektiv eigentlich zwei Digitalstrukturen zugeordnet ist.

Für diese Maßnahme, das betreffende Kollektiv bzw. die streifenförmigen Belegungen eines solchen Kollektivs reflexionsfrei wirkend zu machen, stehen im Rahmen der vorliegenden Erfindung drei Alternativen zur Verfügung, wobei im Einzelfall eine dieser Varianten Vorzüge gegenüber den anderen beiden Varianten haben kann bzw. eine der Varianten nur im Einzelfall nutzbar ist. Die erste dieser Varianten besteht darin, die in dem deutschen Patent DE-C 29 09 705 (bzw. US-Patent US-A-4 325 037)und in der EP-A-0 178 655 (veröffentlicht am 23.4.1986) beschriebenen Maßnahmen der Frequenzverschiebung auf die Struktur des Kollektivs, bezogen auf die zugehörige oder auf die die Mittenfrequenz $f_0$ des Filters bestimmende Digitalstruktur anzuwenden. Das bedeutet, daß das Kollektiv hinsichtlich der Abstände seiner streifenförmigen Belegungen, die Abstände gemessen in Wellenlängeneinheiten, so bemessen wird, daß die Frequenz $f_R$ der (ersten) Nullstelle der interdigitalen Reflexionen an den Belegungen des Kollektivs mit der Mittenfrequenz $f_0$ der Welle des Filters wenigstens im wesentlichen zusammenfällt. Dann sind interdigitale Reflexionen des Kollektivs für das Filter nicht mehr wirksam, wobei gemäß den Vorschriften dieser Maßnahme des obengenannten Patents die Bandbreite des Kollektivs wenigstens so groß zu belassen ist, daß sie wenigstens das Doppelte der Bandbreite des Filters ausmacht. Dies ist jedoch ohne jede Schwierigkeit einzuhalten, indem man die Länge der Struktur des Kollektivs begrenzt, wobei für das Problem egalisierter Belichtung stets genügend viele (wenigstens 20 bis 50) streifenförmige Belegungen des Kollektivs vorzusehen sind bzw. vorliegen.

Die zweite Alternative ist die Aufteilung der streifenförmigen Belegungen des Kollektivs in Gruppen, die aus jeweils wenigen (z.B. zwei bis zehn Streifen) bestehen, und diese einzelnen Gruppen gegeneinander um zusätzliche Viertelwellenlängen-Abstandswerte voneinander entfernt anzuordnen, so daß diese einzelnen Gruppen des Kollektivs miteinander destruktiv interferieren, d.h. gegenseitige Auslöschung der an den einzelnen Gruppen jeweils reflektierten Anteile bewirken.

Die dritte Alternative ist, eine solche Schrägstellung der streifenförmigen Belegungen eines Kollektivs vorzusehen, daß an den streifenförmigen Belegungen des Kollektivs auftretende Reflexionen derart aus dem Filter herausgelenkt werden, daß sie nicht mehr in den einen oder die mehreren Wandler des Filters eintreten können. Letztere Alternative ist jedoch nur bei einem Kollektiv anwendbar, das am äußersten Ende des Filters angeordnet ist, d.h. sich dort befindet, wo keine Sollwelle des Filters mehr auftritt, die dann ebenfalls in entsprechendem Maße, und zwar nachteiligerweise, nach außen abgelenkt werden würde.

Es sei darauf hingewiesen, daß auch an den streifenförmigen Belegungen der Kollektive interdigitale Reflexionen auftreten. Diese sind aber bei der Erfindung für das Filter unwirksam bzw. wenigstens unschädlich gemacht.

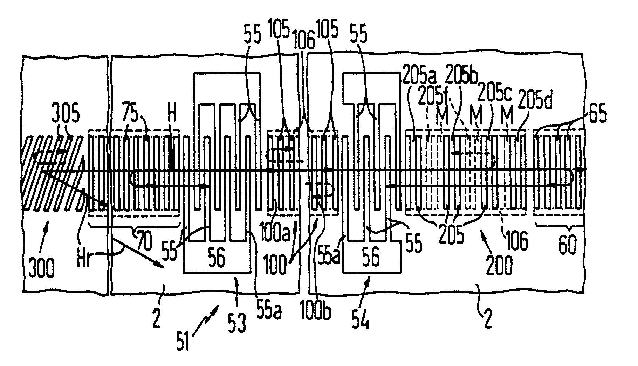

Weitere Erläuterungen der Erfindung gehen aus der nachfolgenden, anhand der Figur gegebenen Beschreibung eines mehrere Varianten aufzeigenden Ausführungsbeispiels der Erfindung hervor.

Die Figur zeigt eine drei alternative, wahlweise einzeln oder zusammen zu verwendende Ausgestaltungen umfassende Ausführungsform der Erfindung, wobei diese Alternativen speziell die Maßnahmen betreffen, das jeweilige Kollektiv reflexionsfrei wirksam zu machen bzw. für das Filter nicht reflektierend wirksam zu machen.

Die in der Figur dargestellten Strukturen des Filters 51 befinden sich auf der Oberfläche eines nur ausschnittsweise dargestellten piezoelektrischen Substrats 2. Mit 53 ist eine erste Interdigitalstruktur und mit 54 eine zweite Interdigitalstruktur bezeichnet, die beide als Wandler, z.B. als Eingangswandler und als Ausgangswandler, zu verwenden sind. Die streifenförmigen Belegungen (Finger, Digitstreifen) dieser Interdigitalstrukturen sind mit 55 bezeichnet. Mit 56 sind Pads bezeichnet, die jeweils gleichzeitig als Sammelschiene für die interdigital ineinandergreifenden streifenförmigen Belegungen 55 dienen.

Wie aus der Figur ersichtlich, haben die beiden Interdigitalstrukturen 53 und 54 einen Abstand voneinander, der aus elektrischen und/oder akustischen Gründen des Filters 51 vorgesehen sein kann oder notwendig ist. Im Stand der Technik ist dies freie Substratoberfläche. Bei der Erfindung und entsprechend der Darstellung der Figur enthält dieser Zwischenraum zwischen den beiden Interdigitalstrukturen 53 und 54 weitere streifenförmige Belegungen 105, wobei in der Figur lediglich je drei streifenförmige Belegungen 105 des erfindungsgemäß vorgesehenen Kollektivs 100 dargestellt sind.

Allgemein hat ein erfindungsgemäß vorgesehenes Kollektiv wenigstens 20 bis 50 streifenförmige Belegungen 105. An sich ist es ausreichend, wenn eine solche Anzahl streifenförmige Belegungen 105 auf die jeweils äußerste streifenförmige Belegung 55a der Interdigitalstruktur 53 bzw. der Interdigitalstruktur 54 folgt. Im mittleren Bereich des Kollektivs gelegene streifenförmige Belegungen 105 des Kollektivs 100 können auch weggelassen sein, und dennoch wird das notwendige Maß an Egalisierung der Belichtung für die jeweils äußersten streifenförmigen Belegungen 55 und für das Filter die Unwirksamkeit der interdigitalen Reflexionen an den Belegungen 105 des Kollektivs 100 erreicht.

Im Falle des Weglassens streifenförmiger Belegungen 105 im mittleren Bereich des Kollektivs 100 kann auch betrachtet werden, als wären stattdessen zwei Kollektive 100a und 100b vorgesehen, wobei das. Kollektiv 100a der Digitalstruktur 53 und das Kollektiv 100b der Digitalstruktur 54 zugeordnet ist.

Es sei darauf hingewiesen, daß ein solches Kollektiv 100 auch mit Sammelschienen 106 versehen sein kann, die wegen dieser Wahlmöglichkeit lediglich gestrichelt dargestellt sind.

Mit 60 ist eine lediglich zu ihrem Anfangsanteil dargestellte Reflektorstruktur des Filters 51 bezeichnet. Diese Reflektorstruktur 60 besteht aus streifenförmigen Belegungen 65, die nach üblichen Regeln für Oberflächenwellenfilter und den Vorgaben für dieses Filter in (Wellenlängen-)Abständen voneinander angeordnet sind. Mit 66 sind, weil nur wahlweise vorgesehen, gestrichelt dargestellte Sammelschienen bezeichnet.

Der Zwischenraum zwischen der Interdigitalstruktur 54 und dieser Reflektorstruktur 60 ist erfindungsgemäß mit einem Kollektiv 200 ausgefüllt, das aus streifenförmigen Belegungen 205 besteht. Diese streifenförmigen Belegungen 205 sind in, wie dargestellt, vier Gruppen 205a bis 205d aufgeteilt. Die streifenförmigen Belegungen 205 dieses Kollektivs 200 dienen der Egalisierung der Belichtung bei der fotolithografischen Herstellung der Interdigitalstruktur 54 und der Reflektorstruktur 60.

Mit 70 ist eine weitere Reflektorstruktur des Filters 51 bezeichnet, die sich bei diesem Beispiel lückenlos an die Interdigitalstruktur 53 anschließt. Ein erfindungsgemäßes Kollektiv zwischen der Interdigitalstruktur 53 und der Reflektorstruktur 70 ist dementsprechend nicht erforderlich. Die dargestellte Ausführungsform hat jedoch ein erfindungsgemäß vorgesehenes Kollektiv 300, das sich an das linksseitige Ende der Reflektorstruktur 70 anschließt. Die streifenförmigen Belegungen 305 dienen ebenfalls dazu, bei der Belichtung während der fotolithografischen Herstellung der Reflektorstruktur 70 dafür Sorge zu tragen, daß auch die linksseitig letzten streifenförmigen Belegungen 75 der Reflektorstruktur 70 ebenso optimal belichtet werden, wie die streifenförmigen Belegungen des mittleren Bereichs der Reflektorstruktur 70.

Wie bereits oben ausdrücklich darauf hingewiesen worden ist, gehört zur Erfindung, daß die Kollektive 100 bzw. 100a/100b, 200 und 300 für das Filter 51 reflexionsfrei wirksam sind.

Die streifenförmigen Belegungen 105 des Kollektivs 100 (das gleiche gilt für stattdessen vorgesehene Kollektive 100a und 100b) sind gemäß einer ersten Variante der Erfindung derart in (Mitten-)Abständen voneinander angeordnet, die nach der Lehre des obengenannten deutschen Patents bemessen sind. Quantitativ sind die (Mitten-) Abstände der streifenförmigen Belegungen 105 des Kollektivs 100 etwas größer oder etwas kleiner bemessen als die (Mitten-)Abstände der streifenförmigen Belegungen derjenigen Struktur, die die Mittenfrequenz des Filters 51 bestimmt. Es ist dies diejenige Struktur, die die geringste Bandbreite des Filters 51 hat. Größerer oder kleinerer Abstand der streifenförmigen Belegungen 105 des Kollektivs 100 hängt davon ab, welche der beiden Nullstellen der interdigitalen Reflexionen des Kollektivs für die Bemessung zugrundegelegt worden ist. Weitere Einzelheiten für die für diese Alternative des Kollektivs 100 zu wählende Bemessung sind dem Fachmann aus dem obengenannten Patent bekannt.

Mit Hilfe einer anderen für die Erfindung zu verwendenden Variante ist das Kollektiv 200 für das Filter 51 reflexionsfrei wirksam gemacht. Innerhalb der einzelnen Gruppen 205a, 205b, 205c und 205d haben die (bei der dargestellten Ausführungsform der Erfindung jeweils zwei) streifenförmigen Belegungen 205 einen Mittenabstand (in der Größe einer halben Wellenlänge der Welle des Filters 51) entechend den Strukturen 53, 54, 60 und/oder 70 des Filters 51. Dies schließt auch weggelassene streifenförmige Belegungen ein, die in der Figur mit 205f bezeichnet sind. Bei dem Kollektiv 200 ist aber zwischen einer Gruppe 205a und einer Gruppe 205d usw. diese Periodizität der Abstände nicht eingehalten. Einem Merkmal dieser Variante gemäß ist der jeweilige Abstand zwischen zwei benachbarten Gruppen um das Maß M einer zusätzlichen Viertelwellenlänge vergrößert. Ist die Breite der streifenförmigen Belegungen (wie häufig) gleich einer Viertelwellenlänge bemessen, ist der Abstand zwischen zwei Gruppen 200a, 200b ... (wie in der Figur) gerade um eine Streifenbreite vergrößert. Statt des Einfachen einer Viertelwellenlänge, kann dies auch das Dreifache oder das Fünffache usw. einer Viertelwellenlänge sein. Mit dieser Maßnahme ist erreicht, daß die interdigitalen Reflexionen an den streifenförmigen Belegungen 205 der Gruppe 205a mit den interdigitalen Reflexionen an den streifenförmigen Belegungen 205 der Gruppe 205b interferieren und sich gegenseitig auslöschen. Entsprechend viele Gruppen 205a ... entsprechend dieser erfindungsgemäßen Maßnahme gegeneinander versetzt, lassen erreichen, daß das ganze Kollektiv 200 für die Welle des Filters 51 keine interdigitalen Reflexionen aufweist.

Auch für das Kollektiv 300 ist Sorge getragen, daß keine interdigitalen Reflexionen von den streifenförmigen Belegungen 305 dieses Kollektivs in das Filter 51 gelangen. Bei diesem endständigen Kollektiv 300 kann dies in besonders einfacher Weise durch Schrägstellung der steifenförmigen Belegung 305 erreicht werden. Die waagerechte mit Doppelpfeilen in der Figur dargestellte Linie deutet die auf Hauptwellenausbreitungsrichtung H des Filters 51 an. Mit Hr ist die Richtung der Reflexion an den schräggestellten streifenförmigen Belegungen 305 dargestellt. Die interdigitalen Reflexionen mit dem Winkel der Richtung Hr reflektiert einen solchen Wellenanteil aus dem Filter 51 hinaus. Durch diese Schrägstellung ist auch dieses Kollektiv 300 für das Filter 51 reflexionsfrei wirksam gemacht.

Beim dargestellten und beschriebenen Ausführungsbeispiel ist für das (in der Figur nicht mehr dargestellte) rechtsseitige Ende der Reflektorstruktur 60 kein Kollektiv vorgesehen. Dort ein solches Kollektiv wegzulassen kommt -ohne daß damit gegen den Gedanken der Erfindung verstoßen werden würde- dann in Betracht, wenn diese Reflektorstruktur 60 aus einer relativ so großen Anzahl von streifenförmigen Belegungen 65 besteht, daß von diesem rechtsseitigen Ende der Reflektorstruktur 60, d.h. von dem hinsichtlich des Filters 51 äußersten Ende der Reflektorstruktur 60 ohnehin kaum noch ein wesentlicher Signalanteil zurückreflektiert wird. Ungenauigkeiten der Präzision und Schärfe von streifenförmigen Belegungen 65, die am äußersten rechten Ende der Reflektorstruktur 60 positioniert sind, haben auf ein, wie dargestelltes Filter 51, praktisch keinen störenden Einfluß mehr. Ganz im Gegensatz dazu würden natürlich große Störungen von solchen streifenförmigen Belegungen 65 der Reflektorstruktur 60 ausgehen, die zum (in der Figur) linksseitigen Ende bzw. in der linken Hälfte der Reflektorstruktur 60 positioniert sind, denn diese streifenförmigen Belegungen 65 der Reflektorstruktur 60 liefern den wesentlichen Anteil des in der Reflektorstruktur 60 bestimmungsgemäß zu reflektierenden Wellensignals.

In der Figur ist mit H die bestimmungsgemäße Laufrichtung der Welle in dem Filter 51 bezeichnet. Die mit ausgezogenen Linien bogenförmig dargestellt umkehrenden Richtungen Hs sind Sollreflexionen des Filters 51 bzw. seiner Reflektorstrukturen 60 und 70. Die gestrichelt dargestellten bogenförmigen Umkehrungen beziehen sich dagegen auf solche in den Kollektiven 100 und 200 auftretende interdigitale Reflexionen, die aufgrund der einen erfindungsgemäßen Maßnahme (nach dem Prinzip der ersten und der zweiten oben beschriebenen Alternative) für das Filter 51 unwirksam gemacht sind, d.h. als Signalanteile im Filter 51 nicht auftreten.

Für die Erfindung wichtig ist, daß zwischen der jeweils ersten bzw. letzten streifenförmigen Belegung einer der Digitalstrukturen 53, 54, 60, 70 des Filters 51 und dem hinzugefügten, zugeordneten Kollektiv 100, 100a, 100b, 200, 300 (oder zwischen aneinanderstoßende Digitalstrukturen 53 und 70) keine oder höchstens nur ganz wenige streifenförmige Belegungen weggelassen sind. Dem steht nicht entgegen, daß am äußeren Ende der Reflektorstruktur 60 kein Kollektiv vorgesehen ist, (weil dieses Ende der Struktur 70 ohnehin wenig wirksam ist).

Nachfolgend werden Bemessungen angegeben, die für ein Filter nach der Erfindung typisch sind. Eine Wandlerstruktur 53, 54 hat z.B. 10 bis 400, vorzugsweise 50 bis 150, streifenförmige Belegungen 55 in interdigitaler Anordnung.

Eine Reflektorstruktur 60, 70 hat z.B. 200 bis 1000, vorzugsweise 400 bis 700, streifenförmige Belegungen 65, 75.

Die jeweilige Anzahl streifenförmiger Belegungen einer Wandler- oder Reflektorstruktur richtet sich nach der jeweils vorgegebenen Bandbreite für diese Struktur.

Breite und (Mitten-)Abstand der streifenförmigen Belgungen voneinander ist durch die vorgegebene Frequenz bzw. Wellenlänge der akustischen Welle und durch die Fortpflanzungsgeschwindigkeit der Welle im Substratkörper gegeben. Übliche Werte für die Streifenbreite sind 0,5 bis 5 μm und für den Mittenabstand 1 bis 10 μm.

Die Länge der einzelnen streifenförmigen Belegungen wird üblicherweise zwischen 20 und 200 Wellenlängen bemessen.

Die voranstehende Beschreibung der Erfindung berücksichtigt die Herstellung der Digitalstrukturen nach dem Prinzip der Abhebetechnik (lift-off-Technik). Bei dieser Technik wird (positiv-) fotoempfindlicher Lack verwendet. Auf der Substratoberfläche wird zunächst eine ganzflächige Beschichtung mit derartigem Fotolack vorgenommen. Es erfolgt dann die den gewünschten Strukturen entsprechende Belichtung, und zwar werden diejenigen Flächenanteile der auf der Substratoberfläche befindlichen Schicht belichtet, die später streifenförmige Belegungen, Pads und Sammelschienen sind. Nach dem Entwickeln wird der belichtete Anteil des Fotolacks abgelöst und die ganze Oberfläche (freigelegte Flächenanteile der Substratoberfläche und noch verbliebener Fotolack) mit einer Metallschicht überzogen (bedampft). Schließlich werden die noch zurückgebliebenen Flächenanteile des Fotolacks abgelöst, dabei von der Metallschicht die Anteile abgehoben, die sich auf Fotolack befinden, und es bleiben die gewünschten Strukturen als metallische Belegungen auf der Substratoberfläche zurück.

Sozusagen der entgegengesetzte Prozeß ist die (mit dem gleichen Endergebnis erfolgende) Herstellung der Strukturen nach einem Prinzip der Ätztechnik. Dabei wird zunächst die Substratoberfläche mit einer Metallschicht überzogen. Diese Metallschicht wird mit der Fotolackschicht überzogen und es erfolgt nunmehr die Belichtung, hier aber derjenigen Flächenanteile, die beim fertigen Filter frei von Metallisierungen der Substratoberfläche sind. Nach dem Entwickeln des belichteten Fotolacks erfolgt das Ablösen, wobei die darunter befindliche, auf der Substratoberfläche vorhandene Metallisierungsschicht in den Flächenanteilen freigelegt wird, die beim fertigen Filter frei von Metallisierung der Substratoberfläche sein müssen. Durch nach folgendes Ätzen werden diese freigelegten Anteile der Metallisierungsschicht von der Substratoberfläche entfernt und es bleiben die während des Ätzens durch die noch verbliebenen Flächenanteile der Fotolackschicht geschützten Anteile der ursprünglichen Metallisierung der Substratoberfläche als gewünschte Die Abhebetechnik und die Ätztechnik unterscheiden sich darin, daß die jeweils komplementären Flächenanteile zu belichten sind.

## Patentansprüche

1. Mit akustischen Wellen arbeitendes elektrisches Filter mit einer Anzahl Digitalstrukturen, die jeweils streifenförmige Belegungen der Oberfläche des Substrats des Filters aufweisen, wobei diese Digitalstrukturen in Längs- bzw. Laufrichtung der Welle des Filters angeordnet sind, und die einzelnen Strukturen Wandlerstrukturen oder Resonatorstrukturen sind, **gekennzeichnet** dadurch, daß am in dieser Laufrichtung (H) freien Ende einer solchen Digitalstruktur (53, 54, 60, 70) ein Kollektiv (100, 200, 300), bestehend aus weiteren streifenförmigen Belegungen (105, 205, 305), die mit den streifenförmigen Belegungen (55, 65, 75) der betreffenden Digitalstruktur (53, 54, 60, 70) hinsichtlich der größenmäßigen Ausdehnung vergleichbar sind, hinzugefügt ist, wobei diese streifenförmigen Belegungen des jeweiligen Kollektivs (100, 200, 300) in bezug auf die streifenförmigen Belegungen (55, 65, 75) der betreffenden Digitalstruktur (53, 54, 60, 70) so positioniert sind, daß das jeweilige Kollektiv (100, 200, 300) der hinzugefügten streifenförmigen Belegungen (105, 205, 305) bezogen auf und für die Welle des Filters (51) reflexionsfrei wirksam ist.

2. Filter nach Anspruch 1, **gekennzeichnet** dadurch, daß der Zwischenraum zwischen zwei in Laufrichtung (H) aufeinanderfolgenden Digitalstrukturen (53 - 54; 54 - 60) mit einem Kollektiv (100; 200) ausgefüllt ist, wobei innerhalb eines Kollektivs (200) auch einzelne streifenförmige Belegungen (205f) weggelassen sein können.

3. Filter nach Anspruch 1, **gekennzeichnet** dadurch, daß ein einer Digitalstruktur des Filters (51) hinzugefügtes Kollektiv zwischen etwa 20 und 50 streifenförmige Belegungen (105, 205, 305) aufweist.

4. Filter nach Anspruch 1 oder 2, **gekennzeichnet** dadurch, daß die streifenförmigen Belegungen (105) eines Kollektivs (100) in (Mitten-)Abständen voneinander angeordnet sind, die um ein Maß abweichend von den (Mitten-)Abständen von streifenförmigen Belegungen (55, 65, 75) derjenigen Digitalstruktur des Filters (51) sind, die die Mittenfrequenz ($f_0$) des Filters bestimmt, wobei dieses Maß der Abweichung so bemessen ist, daß die Frequenz ($f_R$) der ersten Nullstelle der interdigitalen Reflexionen der streifenförmigen Belegungen (105) des Kollektivs (100) mit der Mittenfrequenz ($f_0$) des Filter (51) zusammenfällt.

5. Filter nach Anspruch 1 oder 2, **gekennzeichnet** dadurch, daß die streifenförmigen Belegungen (205) eines Kollektivs (200) in Gruppen (205a bis 205d) aufgeteilt sind, wobei benachbarte Gruppen untereinander (205a - 205b; 205b - 205c ...) hinsichtlich ihrer (Mitten-)Abstände zwischen jeweils der letzten streifenförmigen Belegung der einen Gruppe und der ersten streifenförmigen Belegung der folgenden Gruppe voneinander so angeordnet sind, daß diese Abstände um eine (bzw. ein ungradzahliges Vielfaches einer) Viertelwellenlänge verschieden sind von den Periodenabständen der die Mittenfrequenz ($f_O$) des Filters (51) bestimmenden Digitalstruktur.

6. Filter nach einem der Ansprüche 1 bis 5, **gekennzeichnet** dadurch, daß ein in dem Filter (51) in Laufrichtung (H) endständiges Kollektiv (300) streifenförmige Belegungen (500) besitzt, die derart schräg im Winkel zur Laufrichtung (H) angeordnet sind, daß die interdigitalen Reflexionen an den streifenförmigen Belegungen (305) dieses Kollektivs (300) in Schrägrichtung (Hr) aus dem Filter (51) herausreflektiert sind.

## Claims

1. Electric acoustic-wave filter having a number of digital structures which in each case exhibit strip-shaped coatings on the surface of the substrate of the filter, these digital structures being arranged in the longitudinal direction or direction of propagation of the wave in the filter, and the individual structures being transducer structures or resonator structures, characterised in that, on the free end of such a digital structure (53, 54, 60, 70) in this direction of propagation (H), an ensemble (100, 200, 300) is added, consisting of further strip-shaped coatings (105, 205, 305) which are comparable in terms of the magnitude of their extent to the strip-shaped coatings (55, 65, 75) of the associated digital structure (53, 54, 60, 70), these strip-shaped coatings of the respective ensemble (100, 200, 300) being positioned with respect to the strip-shaped coatings (55, 65, 75) of the associated digital structure (53, 54, 60, 70) such that the respective ensemble (100, 200, 300) of the added strip-shaped coatings (105, 205, 305) acts in a reflection-free manner with respect to and for the wave in the filter (51).

2. Filter according to Claim 1, characterised in that the intermediate space between two successive digital structures (53 - 54; 54 - 60) in the direction of propagation (H) is filled with an ensemble (100, 200), it also being possible to omit individual strip-shaped coatings (205f) within an ensemble (200).

3. Filter according to Claim 1, characterised in that an ensemble added to a digital structure of the filter (51) exhibits between approximately 20 and 50 strip-shaped coatings (105, 205, 305).

4. Filter according to Claim 1 or 2, characterised in that the strip-shaped coatings (105) of an ensemble (100) are arranged at (centre) spacings from each other which are (sic) by an amount deviating from the (centre) spacings between the strip-shaped coatings (55, 65, 75) of that digital structure of the filter (51) which determines the centre frequency ($f_O$) of the filter; this amount of deviation being of such dimensions that the frequency ($f_R$) of the first null point of the interdigital reflections by the strip-shaped coatings (105) of the ensemble (100) coincides with the centre frequency ($f_O$) of the filter (51).

5. Filter according to Claim 1 or 2, characterised in that the strip-shaped coatings (205) of an ensemble (200) are divided into groups (205a to 205d), adjacent groups (205a - 205b; 205b - 205c ...) being mutually arranged on the basis of their (centre) spacings between in each case the last strip-shaped coating of the one group and the first strip-shaped coating of the following group, such that these spacings differ by a quarter wavelength (or an odd-numbered multiple thereof) from the period spacings of the digital structure determining the centre frequency ($f_O$) of the filter (51).

6. Filter according to one of Claims 1 to 5, characterised in that an ensemble (300) at the end in the direction of propagation (H) in the filter (51) has strip-shaped coatings (500) which are arranged at an oblique angle to the direction of propagation (H) in such a manner that the interdigital reflections at the strip-shaped coatings (305) of this ensemble (300) are reflected outwards from the filter (51) in an oblique direction (Hr).

## Revendications

1. Filtre électrique opérant avec des ondes acoustiques et comportant plusieurs structures digitées, qui comportent chacune des revêtements en forme de bandes situées sur la surface du substrat du filtre, et dans lequel ces structures digitées sont disposées dans la direction longitudinale ou dans la direction de propagation de l'onde du filtre et les différentes structures sont des structures de transducteurs ou des structures de résonateurs, caractérisé par le fait qu'à l'extrémité, libre dans cette direction de propagation (H), d'une telle structure digitée (53,54,60,70) est ajouté un ensemble (100,200,300) constitué par d'autres revêtements en forme de bandes (105,205,305), qui du point de vue des dimensions sont comparables aux revêtements en forme de bandes (55,65,75) de la structure digitée considérée (53,54,60,70), ces revêtements en forme de bandes de l'ensemble respectif (100,200,300) étant disposés par rapport aux revêtements en forme de bandes (55,65,75) de la structure digitée considérée (53,54,60,70) de telle sorte que l'ensemble respectif (100,200,300) des revêtements en forme de bandes (105,205,305) ajoutés, agit sans réflexion en rapport avec et pour l'onde du filtre (51).

2. Filtre selon la revendication 1, caractérisé par le fait que l'espace intercalaire entre deux structures digitées (53-54; 54-60) qui se succèdent dans la direction de propagation (H) est rempli par un ensemble (100;200), à l'intérieur duquel peuvent être également supprimés des revêtements individuels en forme de bandes (205f).

3. Filtre suivant la revendication 1, caractérisé par le fait qu'un ensemble, ajouté à une structure digitée du filtre (51), comporte entre environ 20 et 50 revêtements en forme de bandes (105,205,305).

4. Filtre suivant la revendication 1 ou 2, caractérisé par le fait que les revêtements en forme de bandes (105) d'un ensemble (100) sont situés à des distances réciproques (entre centres), qui diffèrent, d'une certaine valeur, des distances (entre centres) de revêtements en forme de bandes (55,65,75) de la structure digitée du filtre (51), qui détermine la fréquence centrale ($f_0$) du filtre, cette valeur de différence étant dimensionnée de manière que la fréquence ($f_R$) de la première annulation des réflexions interdigitées des revêtements en forme de bandes (105) de l'ensemble (100) coïncide avec la fréquence centrale ($f_0$) du filtre (51).

5. Filtre suivant la revendication 1 ou 2, caractérisé par le fait que les revêtements en forme de bandes (205) d'un ensemble (200) sont répartis en groupes (205a à 205d), des groupes voisins étant séparés les uns des autres (205a-205b; 205b-205c ...), pour ce qui concerne les distances (entre centres) entre respectivement le dernier revêtement en forme de bande d'un groupe et le premier revêtement en forme de bande du groupe suivant, de telle sorte que ces distances diffèrent d'un quart de longueur d'onde (ou d'un multiple impair d'un quart de longueur d'onde), des distances périodiques de la structure digitée déterminant la fréquence centrale ($f_0$) du filtre (51).

6. Filtre suivant l'une des revendications 1 à 5, caractérisé par le fait qu'un ensemble (300), qui est un ensemble terminal dans la direction de propagation (H) dans le filtre (51), possède des revêtements en forme de bandes (500), qui sont disposés obliquement par rapport à la direction de propagation (H) de telle sorte que les réflexions interdigitées sur les revêtements en forme de bandes (305) de cet ensemble (300) sortent par réflexion hors du filtre (51) dans une direction oblique (Hr).